# EUROPÄISCHE PATENTSCHRIFT

(11) **EP 0 739 096 B1**
(45) Veröffentlichungstag und Bekanntmachung des Hinweises auf die Patenterteilung: **30.09.1998**
(21) Anmeldenummer: 96102454.4
(22) Anmeldetag: 19.02.1996
(51) Int. Cl.: H03K 17/97, H01H 36/00

(54) **Elektrische Schalteinrichtung**
Electrical switching device
Dispositif électrique de commutation

(30) Priorität: 21.04.1995 DE 19514708
(43) Veröffentlichungstag der Anmeldung: 23.10.1996
(73) Patentinhaber: Leopold Kostal GmbH & Co. KG, 58507 Lüdenscheid (DE)
(72) Erfinder: Garneyer, Stefan, 58097 Hagen (DE); Rimke, Kersten, D-58849 Herscheid (DE); Bieling, Michael, D-58710 Menden (DE)

(56) Entgegenhaltungen:
- DD-A- 136 675
- DD-A- 147 178
- DE-A- 3 333 497
- DE-C- 4 119 316
- GB-A- 1 421 056

## Beschreibung

Die vorliegende Erfindung geht von einer gemäß dem Oberbegriff des Hauptanspruches konzipierten elektrischen Schalteinrichtung aus.

Derartige - insbesondere den Halleffekt nutzende - Geräte sind dafür vorgesehen, um einen elektrischen Stromkreis mit möglichst geringer Schalthysterese präzise ein- bzw. auszuschalten. Solche Schalteinrichtungen sind beispielsweise für die verschiedensten Funktionsbereiche in Kraftfahrzeugen vorgesehen und werden dabei z.B. als Bremslichtschalter, Getriebeschalter usw. eingesetzt.

Durch die DE 33 33 497 A1 ist eine elektrische Schalteinrichtung bekanntgeworden, wobei zwei dauermagnetische Bauteile in einem mehrteiligen Gehäuse angeordnet sind, deren dieselbe Polarisierung aufweisende Pole sich mit Abstand gegenüberliegen. Zwischen diesen Polen der beiden dauermagnetischen Bauteile ist mindestens ein Halleffekt-Schaltbaustein angeordnet. Das erste dauermagnetische Bauteil ist dabei am Betätigungsorgan der Schalteinrichtung befestigt, während das zweite dauermagnetische Bauteil justierbar am Gehäuse gehalten ist. Der Abstand zwischen dem zweiten dauermagnetischen Bauteil und dem Halleffekt-Schaltbaustein wird bei dieser elektrischen Schalteinrichtung über ein Stellmittel eingestellt, wobei der zweite Dauermagnet direkt am Stellmittel festgelegt ist. Bei einem derartig ausgebildeten Gegenstand sind sowohl die beiden dauermagnetischen Bauteile als auch der Halleffekt-Schaltbaustein sowie die dafür vorgesehenen Haltemittel den insgesamt in Gehäuse herrschenden Umweltbedingungen ausgesetzt. Bei aggressiven Umwelteinflüssen kann es deshalb dazu kommen, daß insbesondere der Halleffekt-Schaltbaustein sowie die zugehörigen Haltemittel in ihrer Funktionstüchtigkeit beeinträchtigt werden. Dies kann letztendlich zum Ausfall der elektrischen Schalteinrichtung führen.

Weiterhin ist durch die DE 33 37 122 C2 eine elektrische Schalteinrichtung bekanntgeworden, die aus einem längsverstellbar in einem Gehäuse-Oberteil gehaltenen, als Drucktaste ausgebildeten Betätigungsorgan sowie einem in einem Gehäuse-Unterteil angeordneten, aus einer sogenannten Schaltmatte gebildeten beweglichen Schaltglied und einem auf einer am Gehäuse-Unterteil gehaltenen Isolierstoffplatte angeordneten unbeweglichen Schaltglied besteht. Die Schaltglieder sind dabei aus verschiedenen Elektrodenschichten gebildet. Durch die Aufteilung des Gehäuses in ein Gehäuse-Oberteil und ein Gehäuse-Unterteil sowie die Anordnung der Schaltmatte und des Betätigungsorganes entsteht eine räumliche Trennung von Betätigungsorgan und Schaltgliedern.

Außerdem ist durch die DE 41 19 316 C1 eine dem Oberbegriff des Hauptanspruches entsprechende Schalteinrichtung bekanntgeworden, bei der in einem mehrteiligen Gehäuse zwei durch eine daran vorgesehene Trennwand gebildete, hermetisch voneinander getrennte Gehäuse-Kammern vorhanden sind. Dabei ist dem in einer Gehäuse-Kammer angeordneten Betätigungsorgan der Schalteinrichtung ein dauermagnetisches Bauteil zugeordnet, während in der anderen Gehäuse-Kammer ein von dem dauermagnetischen Bauteil beeinflußbarer Halleffekt-Schaltbaustein vorgesehen ist. Das dauermagnetische Bauteil und der Schaltbaustein sind dabei den beiden Seiten der Trennwand zugeordnet und zwar in sich gegenüberliegender Anordnung.

Bei allen vorgenannten Ausführungsformen besteht das Problem, daß damit nur eine elektrische Schaltfunktion (Ein/Aus) realisierbar ist.

Der vorliegenden Erfindung liegt deshalb die Aufgabe zugrunde, eine elektrische Schalteinrichtung der eingangs erwähnten Art derart weiterzubilden, daß mehrere miteinander verknüpfbare Schaltfunktionen realisierbar sind.

Diese Aufgabe wird durch die im kennzeichnenden Teil des Hauptanspruches angegebenen Merkmale gelöst. Eine solchermaßen aufgebaute elektrische Schalteinrichtung ist dadurch besonders vorteilhaft, daß diese nur relativ wenig mechanisch betätigte Bauteile aufweist. Damit ist ein solches Produkt besonders verschleißarm, wodurch zuverlässig hohe Stellungswechselzahlen erreichbar sind.

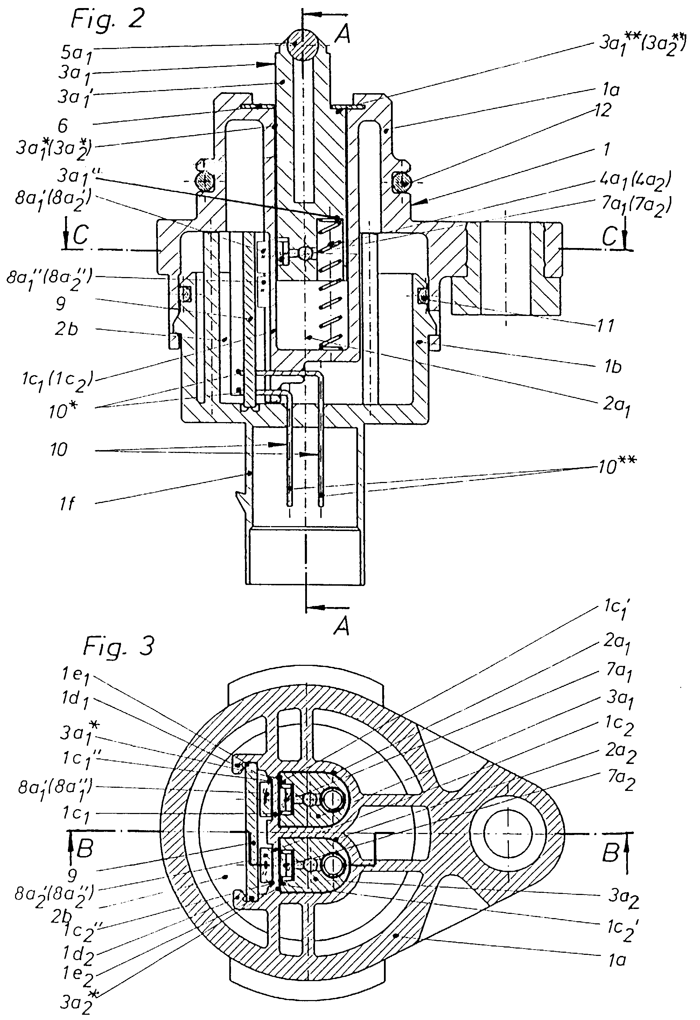

Weitere besonders günstige Ausgestaltungen des erfindungsgemäßen Gegenstandes sind in den Unteransprüchen angegeben und werden anhand eines in der Zeichnung dargestellten Ausführungsbeispieles näher erläutert. Dabei zeigt
- Fig. 1: eine elektrische Schalteinrichtung im Längsschnitt gemäß Linie A-A der Fig. 2
- Fig. 2: die elektrische Schalteinrichtung nach Fig. 1 im Längsschnitt gemäß Linie B-B der Fig. 3
- Fig. 3: die elektrische Schalteinrichtung nach Figuren 1 und 2 im Querschnitt gemäß Linie C-C der Fig. 2

Wie aus der Zeichnung hervorgeht, weist eine elektrische Schalteinrichtung ein im wesentlichen rotationssymmetrisch ausgebildetes, aus einem Gehäuse-Oberteil 1a und einem Gehäuse-Unterteil 1b bestehendes mehrteiliges Gehäuse 1 auf. In dem Gehäuse-Oberteil 1a sind in zwei dort vorhandenen Gehäuse-Kammern 2a₁,2a₂ zwei Betätigungsorgane 3a₁,3a₂ angeordnet. Diese stützen sich jeweils mit ihrem einen Endbereich 3a₁'',3a₂'' über ein als Schraubendruckfeder ausgebildetes Federelement 4a₁,4a₂ am jeweiligen Kammerboden ab, während sie mit ihrem jeweils anderen (freien) Endbereich 3a₁',3a₂' aus der zugehörigen Gehäuse-Kammer 2a₁,2a₂ auf der von dem Gehäuse-Unterteil 1b abgewandten Seite des Gehäuse-Oberteils 1a herausragen. Damit die jeweils z.B. von einem nockenförmigen Ansteuermittel beeinflußbaren Betätigungsorgane nicht aus der zugehörigen Gehäuse-Kammer herausfallen, ist denselben ein Halteelement 6 zugeordnet, welches die Gehäuse-Kammern partiell derart verschließt, daß nur die abgesetzten freien Endbereiche der Betätigungsorgane aus der zugehörigen Gehäuse-Kammer herausragen, während der in jeder Gehäuse-Kammer befindliche andere Endbereich der Betätigungsorgane sich über einen schulterartigen Absatz 3a₁**,3a₂** am Halteelement abstützt und zwar aufgrund der von jedem zugehörigen Federelement aufgebrachten Kraft.

Am äußersten Ende des aus den Gehäuse-Kammern 2a₁,2a₂ herausragenden Endbereichs 3a₁',3a₂' von jedem der beiden Betätigungsorgane ist ein rollenförmiges Verstellelement 5a₁,5a₂ angebracht und zwar um eine einwandfreie Betätigung der Betätigungsorgane 3a₁,3a₂ durch das zugeordnete nockenförmige Ansteuermittel zu ermöglichen.

Im Bereich des in jeder Gehäuse-Kammer 2a₁,2a₂ liegenden Endbereiches der im wesentlichen einen rechteckförmigen Querschnitt aufweisenden Betätigungsorgane ist an einer Längsseite derselben jeweils ein dauermagnetisches Bauteil 7a₁,7a₂ derart eingesetzt, daß es mit seinem magnetischen Aktionselement (Magnetpol-Oberfläche) parallel zu der und in äußerst geringem Abstand von der einen Seite 1c₁',1c₂' der Trennwand 1c₁,1c₂ angeordnet ist.

Auf der anderen Seite 1c₁'',1c₂'' der Trennwand sind in einer durch das Zusammenfügen von Gehäuse-Oberteil und Gehäuse-Unterteil gebildeten Gehäuse-Kammer 2b jeweils zwei von den an den beiden Betätigungsorganen 3a₁,3a₂ vorhandenen dauermagnetischen Bauteilen 7a₁,7a₂ beeinflußbare, vorzugsweise den Halleffekt nutzende Schaltbausteine 8a₁',8a₁''; 8a₂',8a₂'' angeordnet. Diese sind paarweise in Verstellrichtung jedes der beiden Betätigungsorgane hintereinander angeordnet und kommen somit bei der Verstellung von jedem Betätigungsorgan in den Einflußbereich des zugehörigen dauermagnetischen Bauteils.

Die beiden jeweils einem Betätigungsorgan zugeordneten Schaltbausteine sind auf einer ggf. mit elektronischen Bauelementen bestückten Leiterplatte 9 befestigt, die in sich gegenüberliegenden Führungsnuten 1e₁,1e₂ gehalten ist, welche an in der Gehäuse-Kammer 2b vorhandenen, am Gehäuse-Oberteil 1a ausgebildeten Gehäusewandabschnitten 1d₁,1d₂ vorgesehen sind. Die auf der Leiterplatte vorhandenen, mit den Schaltbausteinen elektrisch verbundenen Leiterbahnen sind mit Anschlußenden 10* verbunden, welche an Kontaktteilen 10 vorhanden sind, deren andere Enden 10** als nach außen geführte, von einem Gehäuse-Kragen 1f umgebene Steckkontaktelemente ausgebildet sind.

Da eine solche Schalteinrichtung z.B. als sogenannter Getriebeschalter Verwendung finden kann, muß das Gehäuse 1 einerseits so ausgestaltet sein, daß kein im Getriebe befindliches Öl in die zweite Gehäusekammer 2b, d.h. in den mit den elektrischen Bauelementen bestückten Innenraum eindringen kann. Zu diesem Zweck ist zwischen den miteinander kooperierenden, hohlzylindrischen Bereichen des Gehäuse-Oberteils 1a und des Gehäuse-Unterteils 1b ein umlaufendes ringförmiges Dichtmittel 11 angeordnet. Ein weiteres am Gehäuse-Oberteil vorhandenes Dichtmittel 12 verhindert, daß vom Innenraum des Getriebes her Öl nach außen kommen kann und zwar indem es zwischen der Außenwandung des Gehäuse-Oberteils 1a und der Innenwandung des zur Aufnahme des Gehäuses vorgesehenen Durchbruchs vordringt.

Die Funktion der vorbeschriebenen Schalteinrichtung wird zunächst anhand der Funktion eines Betätigungsorganes näher verdeutlicht.

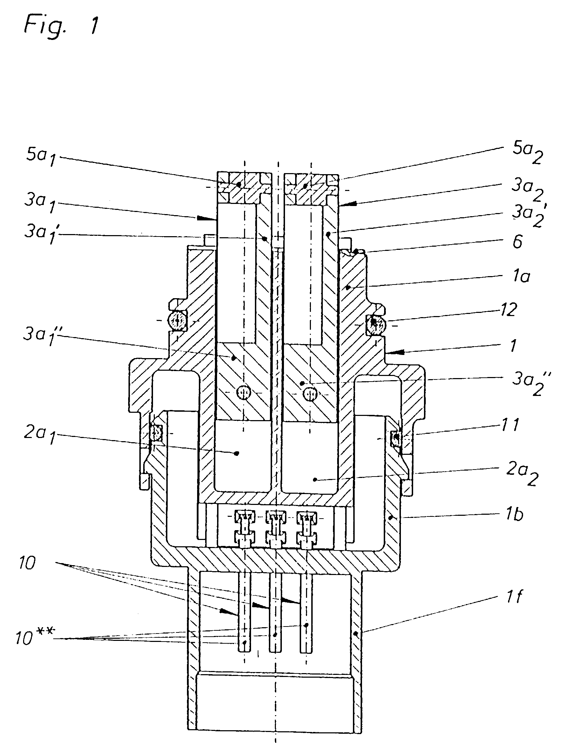

In der in Fig. 1 dargestellten Ruheposition des (einen) Betätigungsorganes 3a₁ befindet sich der eine Schaltbaustein 8a₁' im Einflußbereich des an dem Betätigungsorgan 3a₁ vorhandenen dauermagnetischen Bauteils 7a₁ und weist somit seinen leitenden Zustand auf, während der andere vom dauermagnetischen Bauteil 7a₁ entfernte Schaltbaustein 8a₁'' sich in seinem gesperrten Zustand befindet. Diese beiden Schaltzustände der beiden Schaltbausteine bleiben über einen ersten von der Ausbildung und Anordnung des dauermagnetischen Bauteils und seiner Zuordnung zu dem einen Schaltbaustein abhängigen Verstellbereich des Betätigungsorganes erhalten.

Bei einem weiteren, über den ersten Verstellbereich hinausgehenden Verschieben des Betätigungsorganes geht der eine Schaltbaustein 8a₁' in seinen gesperrten Zustand über, während der andere Schaltbaustein 8a₁'' seinen gesperrten Zustand beibehält.

Diese Schaltzustände der beiden Schaltbausteine bleiben über einen zweiten durch den Abstand der beiden Schaltbausteine voneinander definierten (mittleren) Bereich erhalten. Beim Verlassen des mittleren Bereiches und Eintritt in einen dritten Bereich geht der andere Schaltbaustein in seinen leitenden Zustand über, während der eine Schaltbaustein seinen gesperrten Schaltzustand beibehält. Diese Zustände der beiden Schaltbausteine bleiben dann bis zum Endanschlag des Betätigungsorganes am Kammerboden erhalten und bei der Rückkehr des Betätigungsorganes zu seiner Ruheposition erfolgen sinngemäße Zustandsänderungen der den beiden Schaltbausteinen zugeordneten Schaltfunktionen.

Wird das zweite Betätigungsorgan bzgl. seiner dauermagnetischen Bauteile genauso aufgebaut und die Schaltbausteine genauso angeordnet und damit entsprechend zugeordnet, so läßt sich durch unterschiedliche Ansteuerung über die damit kooperierenden nockenförmigen Ansteuermittel eine entsprechende abhängige Steuerung realisieren. Noch größere Freiheitsgrade werden dann erreicht, wenn den Betätigungsorganen die Schaltbausteine unterschiedlich zugeordnet werden oder wenn jedem Betätigungsorgan mehr als zwei hintereinander liegende Schaltbausteine oder dauermagnetische Bauteile zugeordnet werden.

## Patentansprüche

1. Elektrische Schalteinrichtung mit einem mehrteiligen Gehäuse (1) und mit einem in einer Gehäuse-Kammer (2a₁) in Richtung seiner Längsachse verschiebbar angeordneten, stößelartig ausgeführten, ein dauermagnetisches Bauteil (7a₁) aufweisenden Betätigungsorgan (3a₁) das mit einem in einer von der einen Gehäuse-Kammer durch eine Trennwand (1c₁) hermetisch abgetrennten anderen Gehäuse-Kammer (2b) vorhandenen, vom dauermagnetischen Bauteil beeinflußbaren , auf einer elektrischen Leiterplatte (9) angeordneten Schaltbaustein (8a₁',8a₁") kooperiert, wobei das dauermagnetische Bauteil mit seinem Aktionselement der einen Seite (1c₁') der Trennwand und der Schaltbaustein mit seinem Reaktionselement der anderen Seite (1c₁") der Trennwand zugeordnet ist, **dadurch gekennzeichnet**, daß das dauermagnetische Bauteil (7a₁,7a₂) an einer Längsseite (3a₁*,3a₂*) des Betätigungsorganes (3a₁,3a₂) angeordnet ist und sich mit seinem Aktionselement in geringem Abstand von der einen Seite (1c₁',1c₂') der Trennwand (1c₁,1c₂) in Verschieberichtung des Betätigungsorganes erstreckt, daß zusätzlich zu dem auf der anderen Seite (1c₁",1c₂") der Trennwand befindlichen einen Schaltbaustein (8a₁',8a₂') zumindest ein weiterer in der anderen Gehäuse-Kammer (2b) angeordneter Schaltbaustein (8a₁",8a₂") vorhanden ist, der sich in Verschieberichtung des Betätigungsorganes vor oder hinter dem einen Schaltbaustein befindet, daß zusätzlich zu dem in der einen Gehäuse-Kammer (2a₁) vorgesehenen, mit zumindest einem dauermagnetischen Bauteil (7a₁) versehenen einen Betätigungsorgan (3a₁) noch zumindest ein weiteres mit einem dauermagnetischen Bauteil (7a₂) versehenes, parallel zu dem ersten Betätigungsorgan angeordnetes Betätigungsorgan (3a₂) vorhanden ist, daß zusätzlich zu den in der anderen Gehäuse-Kammer (2b) vorgesehenen zumindest zwei Schaltbausteinen (8a₁',8a₁") pro weiteres Betätigungsorgan zumindest zwei weitere, in der anderen Gehäuse-Kammer entsprechend angeordnete Schaltbausteine (8a₂',8a₂") vorhanden sind und daß die Schaltbausteine (8a₁',8a₁";8a₂',8a₂") auf einer gemeinsamen elektrischen Leiterplatte (9) angeordnet sind, die in parallel zur Trennwand (1c₁,1c₂) verlaufenden, in Gehäusewandabschnitten (1d₁,1d₂) vorgesehenen Führungsnuten (1e₁,1e₂) der anderen Gehäuse-Kammer (2b) gehalten ist.

2. Elektrische Schalteinrichtung nach Anspruch 1, dadurch gekennzeichnet, daß jedes zusätzliche Betätigungsorgan (3a₂) in einer parallel zu der einen Gehäuse-Kammer (2a₁) ausgerichteten eigenen Gehäuse-Kammer (2a₂) angeordnet ist.

3. Elektrische Schalteinrichtung nach Anspruch 1, dadurch gekennzeichnet, daß sämtliche parallel zueinander angeordnete Betätigungsorgane (3a₁,3a₂) in einer gemeinsamen Gehäuse-Kammer angeordnet sind.

4. Elektrische Schalteinrichtung nach Anspruch 1, dadurch gekennzeichnet, daß die Leiterbahnen der Leiterplatte (9) mit aus dem Gehäuse (1) herausgeführten Kontaktteilen (10) verbunden sind.

5. Elektrische Schalteinrichtung nach Anspruch 4, dadurch gekennzeichnet, daß die aus dem Gehäuse (1) herausgeführten Enden (10**) der Kontaktteile (10) als Steckkontaktelemente ausgebildet und von einem Gehäuse-Kragen (1f) umgeben sind.

6. Elektrische Schalteinrichtung nach einem der Ansprüche 1 bis 5, dadurch gekennzeichnet, daß das Gehäuse (1) im wesentlichen aus einem Gehäuse-Oberteil (1a) und einem Gehäuse-Unterteil (1b) besteht, daß in dem Gehäuse-Oberteil die zumindest eine Gehäuse-Kammer (2a₁,2a₂) vorhanden ist und daß die andere Gehäuse-Kammer (2b) durch das Zusammenfügen von Gehäuse-Oberteil und Gehäuse-Unterteil gebildet ist.

7. Elektrische Schalteinrichtung nach Anspruch 6, dadurch gekennzeichnet, daß das Gehäuse-Oberteil (1a) und das Gehäuse-Unterteil (1b) mit hohlzylindrisch ausgeführten, miteinander kooperierenden Endbereichen versehen sind, die über ein umlaufendes ringförmiges Dichtmittel (11) einander zugeordnet sind.

8. Elektrische Schalteinrichtung nach Anspruch 6 oder 7, dadurch gekennzeichnet, daß die die Führungsnuten (1e₁,1e₂) aufweisenden Gehäusewandabschnitte (1d₁,1d₂) am Gehäuse-Oberteil (1a) vorgesehen sind.

9. Elektrische Schalteinrichtung nach einem der Ansprüche 6 bis 8, dadurch gekennzeichnet, daß die in dem Gehäuse-Oberteil (1a) vorhandene, zumindest eine Gehäuse-Kammer (2a₁,2a₂) sich bis zum freien Endes desselben erstreckt, daß das Betätigungsorgan (3a₁,3a₂) in der einen Gehäuse-Kammer mit seinem einen Endbereich (3a₁",3a₂") unter der Einwirkung eines Federelementes (4a₁,4a₂) gehalten ist und mit seinem anderen freien Endbereich aus der einen Gehäuse-Kammer (2a₁,2a₂) herausragt und daß das Betätigungsorgan durch ein die Gehäuse-Kammer partiell verschließendes Halteelement (6) gegen ein Herausfallen aus der Gehäuse-Kammer gesichert ist.

10. Elektrische Schalteinrichtung nach einem der Ansprüche 1 bis 9, dadurch gekennzeichnet, daß die Schaltbausteine (8a_{1'},8a_{1"}; 8a_{2'}, 8a_{2"}) als den Halleffekt nutzende Schaltglieder ausgebildet sind.

## Claims

1. Electric switchgear with a multipart housing (1) and an actuating device (3a₁) which features a permanent-magnetic component (7a₁), is designed as a type of plunger, and is arranged in a housing chamber (2a₁) in the direction of its longitudinal axis in a displaceable manner and which cooperates with a switching module (8a₁',8a₁") that is influenced by the permanent-magnetic component and arranged on an printed board (9) situated in another housing chamber (2b) that is hermetically separated from the first housing chamber by a partition (1c₁), whereby the permanent-magnetic component is allocated with its action element on the one side (1c₁') of the partition and the switching module is allocated with its reaction element on the other side (1c₁") of the partition,
**characterized by the fact** that the permanent-magnetic component (7a₁,7a₂) is arranged on one longitudinal side (3a₁*,3a₂*) of the actuating device (3a₁,3a₂) and extends with its action element at a close distance to one side (1c₁', 1c₂') of the partition (1c₁, 1c₂) in the direction of displacement of the actuating device, that in addition to the one switching module (8a₁',8a₂') located on the other side (1c₁", 1c₂") ofthe partition at least one further switching module (8a₁",8a₂") is featured in the other housing chamber (2b) which is situated in the direction of displacement of the actuating device either in front of or behind the first switching module, that in addition to the actuating device (3a₁) in the one housing chamber (2a₁) which is provided with at least one permanent-magnetic component (7a₁), there is at least one further actuating device (3a₂) fitted with one permanent-magnetic component (7a₂) and arranged parallel to the first actuating device, that in addition to the intended minimum of two switching modules (8a₁', 8a₁") in the other housing chamber (2b) per additional actuating device at least two further switching modules (8a₂',8a₂") are fitted in the other housing chamber in a corresponding arrangement and that the switching modules (8a₁',8a₁",8a₂',8a₂") are arranged on a common electric printed board (9) which is held in guide grooves (1e₁,1e₂) running parallel to the partition (1c₁,1c₂) and provided in housing wall sections (1d₁,1d₂) of the other housing chamber (2b).

2. Electric switchgear in accordance with claim 1, characterized by the fact that each additional actuating device (3a₂) is arranged in an individual housing chamber (2a₂) which is aligned parallel to the first housing chamber (2a₁).

3. Electric switchgear in accordance with claim 1, characterized by the fact that all actuating devices (3a₁,3a₂) arranged parallel to each other are mounted in one common housing chamber.

4. Electric switchgear in accordance with claim 1, characterized by the fact that the strip conductors of the printed board (9) are connected with contact parts (10) which project from the housing (1).

5. Electric switchgear in accordance with claim 4, characterized by the fact that the ends (10**) of the contact parts protruding from the housing (1) are designed as plug-type contact elements and are encompassed by a housing collar (1f).

6. Electric switchgear in accordance with one of claims 1 to 5, characterized by the fact that the housing (1) consists essentially of an upper housing constituent (1a) and a lower housing constituent (1b), that at least one housing chamber (2a₁,2a₂) is evident in the upper housing constituent and that the other housing chamber (2b) is formed by joining the upper housing constituent and the lower housing constituent.

7. Electric switchgear in accordance with claim 6, characterized by the fact that the upper housing constituent (1a) and the lower housing constituent (1b) are provided with hollow, intercooperating end zones of cylindrical design which are allocated to each other by way of a surrounding circular sealing agent (11).

8. Electric switchgear in accordance with claim 6 or claim 7, characterized by the fact that the guide grooves (1e₁,1e₂) featured in the wall sections (1d₁,1d₂) of the housing are provided in the upper housing constituent (1a).

9. Electric switchgear in accordance with one of claims 6 to 8, characterized by the fact that the minimum of one housing chamber (2a₁,2a₂) evident in the upper housing constituent (1a) extends to the free end of the same, that the actuating device (3a₁,3a₂) in the one housing chamber is retained with its one end region (3a₁",3a₂") under the influence of a spring element (4a₁,4a₂) and projects with ist other free end region from the one housing chamber (2a₁,2a₂) and that the actuating device is secured against falling out of the housing chamber by means of a retaining element which partially closes the housing chamber.

10. Electric switchgear in accordance with one of claims 1 to 9, characterized by the fact that the switching modules (8_{a1'},8a_{1"},8_{a2'},8_{a2"}) are designed as switching members employing the Hall effect.

## Revendications

1. Dispositif de commutation électrique avec un boîtier (1) composé de plusieurs pièces et avec un organe d'actionnement (3a₁) en forme de poussoir qui, équipé d'un élément à magnétisme permanent (7a₁), est disposé, ajustable dans le sens de son axe longitudinal, dans une chambre (2a) du boîtier et coopère avec un élément de circuit (8a₁', (8a₁") qui, installé sur une plaque à circuit imprimé (9), est logé dans une autre chambre (2b) du boîtier séparée hermétiquement de la chambre (2a) par une cloison de séparation (1c₁') et est soumis à l'influence de l'élément à magnétisme permanent, l'élément à magnétisme permanent étant attribué avec son élément d'action à l'un des côtés (1c₁') de la cloison de séparation et l'élément de circuit étant attribué avec son élément de réaction à l'autre côté (1c₁") de cette cloison de séparation,
caractérisé en ce que
l'élément à magnétisme permanent (7a₁, 7a₂) est disposé sur l'un des côtés longitudinaux (3a₁*, 3a₂*) de l'organe d'actionnement (3a₁, 3a₂)) et s'étend avec son élément d'action à peu de distance de l'un des côtés (1c₁', 1c₂') de la cloison de séparation (1c₁, 1c₂), dans le sens d'ajustage de l'organe d'actionnement,
qu'en plus de l'élément de circuit (8a₁', 8a₂') situé de l'autre côté (1c₁", 1c₂") de la cloison au moins un autre élément de circuit (8a₁", 8a₂"), disposé en amont ou en aval de l'élément de circuit (8a₁', 8a₂') dans le sens d'ajustage de l'organe d'actionnement, est installé dans l'autre chambre (2b) du boîtier,
qu'en plus de l'organe d'actionnemnt (3a₁) équipé d'un élément à magnétisme permanent (7a₁) au moins un autre élément d'actionnement (3a₂) pourvu d'un élément à magnétisme permanent (7a₂) est disposé parallèlement à cet organe d'actionnement (3a₁),
qu'en plus des deux éléments de circuit au moins (8a₁', 8a₁") prévus dans l'autre chambre (2b) du boîtier, au moins deux autres éléments de circuit (8a₂', 8a₂"), disposés adéquatement, sont prévus dans l'autre chambre du boîtier et
que les éléments de circuit (8a₁', 8a₁"; 8a₂', 8a₂") sont installés sur une plaque à circuit imprimé commune (9) qui est maintenue dans des rainures de guidage (1e₁, 1e₂) de l'autre chambre (2b) du boîtier, lesquelles s'étendent parallèlement par rapport à la cloison de séparation (1c₁, 1c₂) et sont prévues dans des secteurde parois (1d₁, 1d₂) du boîtier.

2. Dispositif de commutation électrique selon la revendication 1,
caractérisé en ce que
chaque organe d'actionnement (3a₂) supplémentaire est disposé dans sa propre chambre (2a₂') orientée parallèlement à la chambre (2a₁) du boîtier.

3. Dispositif de commutation électrique selon la revendication 1,
caractérisé en ce que
tous les organes d'actionnement (3a₁, 3a₂) disposés parallèlement par rapport les uns aux autres sont installés dans une chambre commune du boîtier.

4. Dispositif de commutation électrique selon la revendication 1,
caractérisé en ce que
les traces de guidage de la plaque à circuit imprimé (9) sont raccordées à des pièces de contact (10) conduites hors du boîtier (1).

5. Dispositif de commutation selon la revendication 4,
caractérisé en ce que
les extrémités (10**) des pièces de contact (10) conduites hors du boîtier (1) sont conçues sous forme d'éléments de contact enfichables et entourés d'un col (1f) du boîtier.

6. Dispositif de commutation selon l'une des revendications 1 à 5,
caractérisé en ce que
le boîtier (1) consiste essentiellement en une partie supérieure (1a) et une partie inférieure (1b) de boîtier,
qu'au moins une chambre de boîtier (2a₁, 2a₂) est prévue dans la partie supérieure du boîtier et que l'autre chambre (2b) du boîtier est formée par l'assemblage de la partie supérieure et de la partie inférieure du boîtier.

7. Dispositif de commutation électrique selon la revendication 6,
caractérisé en ce que
la partie supérieure (1a) et la partie inférieure (1b) du boîtier sont pourvues de zones d'extrémité en forme de cylindre creux qui coopèrent ensemble et sont subordonnées l'une à l'autre par l'intermédiaire d'un joint d'étanchéité (11) annulaire, continu.

8. Dispositif de commutation électrique selon la revendication 6 ou 7,
caractérisé en ce que
les secteurs de paroi de boîtier (1d₁, 1d₂) présentant les rainures de guidage (1e₁,1e₂) équipent la partie supérieure (1a) du boîtier.

9. Dispositif de commutation électrique selon l'une des revendications 6 à 8,
caractérisé en ce que
l'une des chambres (2a₁,2a₂) au moins prévue dans la partie supérieure (1a) du boîtier s'étend jusqu'à l'extrémité libre de celui-ci,
que l'organe d'actionnement (3a₁,3a₂) est maintenu, sous l'effet d'un élément faisant ressort (4a₁, 4a₂), dans l'une des chambres du boîtier par sa zone d'extrémité (3a₁", 3a₂") tandis que son autre zone d'extrémité libre fait saillie hors de la chambre (2a1,2a2) du boîtier et
que l'organe d'actionnement est assuré contre une chute hors de la chambre du boîtier par un élément de retenue (6) fermant partiellement la chambre du boîtier.

10. Dispositif de commutation selon l'une des revendications 1 à 9,
caractérisé en ce que
les éléments de circuit (8a₁', 8a₁"; 8a₂', 8a₂") sont conçus sous forme d'organes de commutation à effet Hall.
